# DEMANDE DE BREVET EUROPEEN

(11) **EP 3 879 291 A1**
(43) Date de publication de la demande: **15.09.2021**
(21) Numéro de dépôt: 20163003.5
(22) Date de dépôt: 13.03.2020
(51) Int. Cl.: G01R 31/50

(54) **DISPOSITIF DE CONTRÔLE D'INSTALLATIONS ÉLECTRIQUES**

(71) Demandeur: Sallin, Hervé, 1695 Estavayer-le-Gibloux (CH)
(72) Inventeur: Sallin, Hervé, 1695 Estavayer-le-Gibloux (CH)
(74) Mandataire: Omnis-IP

(57) **Abrégé**

La présente invention concerne un dispositif de contrôle d'installations électriques, comportant un boîtier de mesure (11) agencé pour recevoir des valeurs de mesure de paramètres contrôlés. Ce dispositif de contrôle (10) est caractérisé en ce qu'il comporte en outre au moins un boîtier de commande (12) distinct dudit boîtier de mesure (11) et connecté à ce boîtier de mesure (11) par une voie de communication.

La présente invention concerne en outre une méthode de contrôle d'installations électriques au moyen d'un dispositif de contrôle (10) comportant au moins un boîtier de mesure (11) agencé pour recevoir des valeurs de mesure de paramètres testés et un boîtier de commande (12) distinct dudit boîtier de mesure (11) et connecté à ce boîtier de mesure (11) par une voie de communication. La méthode de l'invention comporte les étapes suivantes :
• sélection sur le boîtier de commande (12) et/ou le boîtier de communication (41) d'une mesure à effectuer ;
• mesure des paramètres et de valeurs en fonction de la sélection ;
• transmission de données représentatives des résultats des mesures à un centre de gestion distant.

## Description

### DOMAINE TECHNIQUE

La présente invention concerne de façon générale, le domaine du contrôle d'installations électriques. De façon plus détaillée, elle concerne un dispositif de contrôle d'installations électriques, comportant un boîtier de mesure agencé pour recevoir des valeurs de mesure de paramètres contrôlés.

Elle concerne également une méthode de contrôle d'installations électriques au moyen d'un dispositif de contrôle tel que mentionné ci-dessus.

### ART ANTÉRIEUR

Actuellement, les dispositifs destinés au contrôle ou aux tests d'installations électriques sont formés d'un appareil de mesure et d'une pluralité de câbles et de connecteurs, destinés à contrôler différentes caractéristiques de l'installation électrique. L'appareil de mesure est utilisé pour différentes fonctions et notamment pour sélectionner un type de contrôle ou de mesures à effectuer, pour afficher des informations et des résultats des mesures, pour traiter des mesures et pour éventuellement mémoriser des valeurs mesurées et/ou des résultats du traitement de ces valeurs mesurées.

Ces appareils de mesure sont généralement portés en bandoulière ou sur le ventre par la personne en charge d'effectuer les contrôles ou les tests. Ces appareils peuvent être relativement volumineux et lourds et donc peu pratiques à utiliser. Les constructeurs de tels appareils de mesure doivent faire un compromis entre le côté pratique et les fonctions ou la précision. En effet, plus la précision est grande et/ou plus les fonctions disponibles sont nombreuses, plus l'appareil peut être lourd et encombrant et donc peu commode à utiliser.

Par ailleurs, les appareils existants sont généralement portés en bandoulière ou autour du cou de l'utilisateur, sur le ventre, de façon à permettre l'accès aux réglages et aux choix des fonctions de l'appareil. Dans cette position, l'appareil peut gêner l'utilisateur pour la prise de mesures. Suivant le type de contrôles ou de tests à effectuer, cet utilisateur aura besoin d'une main pour effectuer des mesures avec une pointe de mesure spécifique et une main pour procéder aux réglages de l'appareil de mesure et déclencher la mesure. Dans le cas où une pointe de mesure doit être connectée à une borne ou un câble spécifique, par exemple au câble de terre, il est nécessaire de fixer la pointe de mesure à la borne, par exemple en utilisant une pince crocodile. Ceci rend la manipulation plus compliquée et moins pratique à réaliser.

Les différentes mesures qu'il est nécessaire d'effectuer pour contrôler une installation électrique impliquent la manipulation d'un grand nombre de câbles ou de fils différents, ayant des connecteurs différents ou encore des boitiers connexes. Ces câbles ont tendance à s'emmêler et les manipulations doivent être réalisées de façon très méticuleuse pour éviter des mesures fausses ou des accidents. Selon le type de mesure à réaliser, le nombre de manipulations conséquent contribue au côté peu pratique des appareils actuels.

Une fois les mesures effectuées, elles peuvent être mémorisées dans l'appareil de mesure si cet appareil de mesure dispose d'une mémoire à cet effet. Du fait de contraintes légales liées au contrôle des installations électriques, ces mesures doivent être reportées selon un format prédéfini. Avec les appareils de mesure actuels, la personne en charge d'effectuer les contrôles ou les tests reporte généralement les résultats des mesures manuellement. Ces résultats reportés sont généralement retransmis soit sous format papier, soit sur un dispositif électronique tel qu'un ordinateur ou une tablette. Ces résultats sont alors transmis à une entité de contrôle ou de certification par exemple, au propriétaire et à un exploitant de réseau électrique. Ces différentes retranscriptions sont sources d'erreurs et sont une perte de temps assez importante.

Il existe donc un besoin pour un dispositif de mesure pratique à utiliser, disposant de fonctions permettant d'effectuer les contrôles de façon fiable et précise, qui n'exige pas de compromis de la part du fabricant et qui permette de transmettre les données de façon efficace et en limitant le risque d'erreurs.

### DESCRIPTION DE L'INVENTION

Un tel dispositif est décrit dans la présente invention.

Le but de l'invention est atteint par un dispositif de contrôle tel que défini en préambule et caractérisé en ce que ce dispositif de contrôle comporte en outre au moins un boîtier de commande distinct dudit boîtier de mesure et connecté à ce boîtier de mesure par une voie de communication.

Le but de l'invention est également atteint par une méthode de contrôle d'installations électriques au moyen d'un dispositif de contrôle comportant au moins un boîtier de mesure agencé pour recevoir des valeurs de mesure de paramètres testés et un boîtier de commande distinct dudit boîtier de mesure et connecté à ce boîtier de mesure par une voie de communication, cette méthode comportant les étapes suivantes :
- sélection sur le boîtier de commande et/ou le boîtier de communication d'une mesure à effectuer ;
- mesure des paramètres et de valeurs en fonction de la sélection ;
- transmission de données représentatives des résultats des mesures à un centre de gestion distant.

Le dispositif de mesure selon la présente invention permet de réaliser des contrôles et des tests d'installations électriques de façon pratique et simple. Les fonctions du dispositif de mesure ne sont pas limitées par le poids et/ou le volume de ce dispositif. En effet, dans ce dispositif, les éléments liés aux fonctions disponibles et à la précision sont décorrélés du côté pratique de la mesure de sorte que le dispositif reste commode à utiliser même s'il est capable d'offrir un grand nombre de fonctions et/ou une grande précision de mesure.

Les différentes mesures peuvent être réalisées de façon simple, sans devoir manipuler plusieurs câbles pour chaque mesure, ce qui évite d'emmêler les câbles et d'effectuer des mesures erronées.

En effet, du fait de la structure du dispositif, un câble ou un ensemble de câbles peut être utilisé pour plusieurs mesures ou plusieurs types de mesures distinctes, contrairement aux appareils existants dans lesquels généralement, chaque type de mesure requiert un ensemble de câbles spécifiques.

La structure particulière du dispositif permet également de réaliser certaines mesures sans devoir fixer un câble à une borne, par exemple au moyen d'une pince crocodile, ce qui facilite les mesures et les manipulations du dispositif.

Selon un mode de réalisation particulier de l'invention, il est possible que le dispositif détecte certaines caractéristiques des mesures à effectuer de sorte que certains réglages puissent être effectués de façon automatique. Cette reconnaissance automatique et indépendante de l'utilisateur augmente la fiabilité du dispositif en minimisant le risque que l'utilisateur effectue un réglage erroné ou une fausse manipulation.

L'utilisateur peut également être guidé lors des tests, le dispositif lui indiquant par exemple quelles sont les prochaines mesures à effectuer et les prochaines démarches à entreprendre.

Le dispositif selon l'invention peut en outre être utilisé pour transmettre des valeurs mesurées ainsi que d'autres informations à un centre de gestion. Ces valeurs ou informations peuvent être traitées, formatées et/ou transmises de façon à générer un formulaire contenant les données requises sans devoir reporter manuellement ces données.

Cette transcription et transmission automatique permet un important gain de temps et supprime les risques d'erreurs dues à des retranscriptions manuelles. Ceci permet également d'adapter le format de report des données aux exigences et aux spécificités de l'organe de contrôle ou de certification et/ou à l'exploitant du réseau. Ainsi, les mesures pourraient notamment facilement être adaptées aux exigences nationales de différents pays.

### BRÈVE DESCRIPTION DES DESSINS

La présente invention et ses avantages seront mieux compris en référence aux figures annexées et à la description détaillée de modes de réalisation particuliers, dans lesquelles :
- la figure 1 illustre un premier mode de réalisation d'un dispositif de contrôle selon la présente invention ;
- la figure 2 représente un premier boîtier faisant partie du dispositif de contrôle de l'invention ;
- la figure 3a illustre un deuxième boîtier du dispositif de contrôle de l'invention, dans une première position ;
- la figure 3b illustre le boîtier de la figure 3a, dans une deuxième position ;
- les figures 4 à 11 représentent différents modes de réalisation d'un détail de connecteur du dispositif de contrôle selon l'invention ; et
- la figure 12 illustre un deuxième mode de réalisation du dispositif de contrôle selon la présente invention.

### MODE DE REALISATION DE L'INVENTION

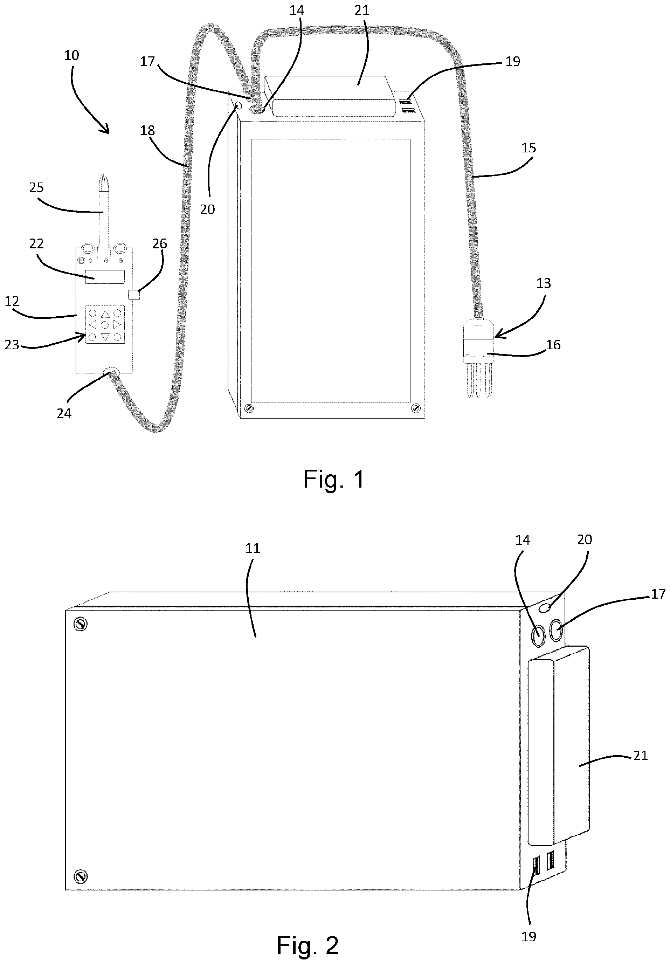

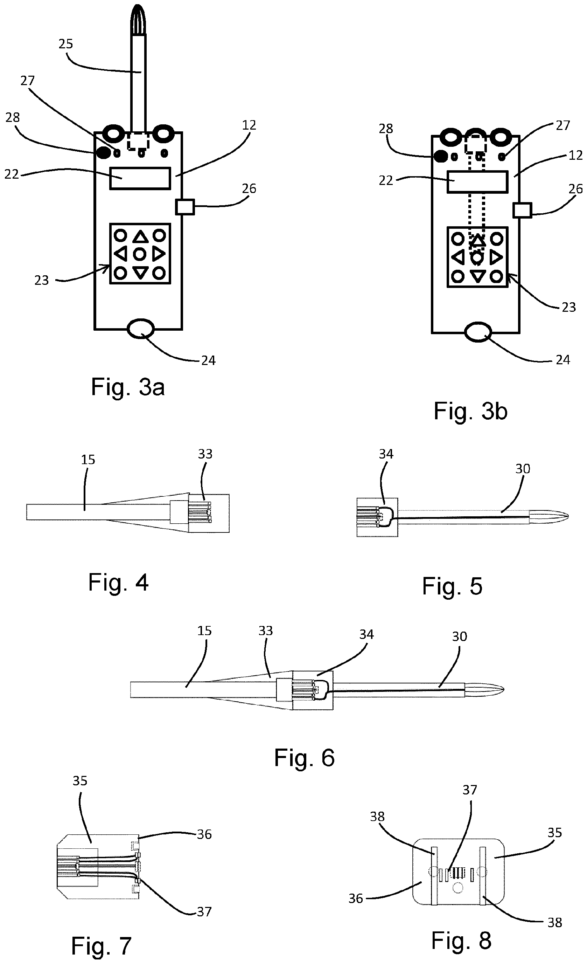

En référence aux figures 1 à 3, le dispositif de contrôle 10 selon la présente invention comporte essentiellement un boîtier de mesure 11, un boîtier de commande 12 et au moins une prise de test 13. Le boîtier de mesure 11, illustré plus en détail par la figure 2, comporte notamment des moyens de traitement de données réalisés sous la forme d'au moins un module électronique de traitement (non représenté) et au moins une mémoire (non représentée) dont la fonction est expliquée plus en détail plus bas. Ce boîtier de mesure 11 comporte également au moins un connecteur 14 prévu pour recevoir un câble 15 connecté à la prise de test 13. Celle-ci peut être interchangeable et peut être réalisée sous la forme d'un module 16 de prise de test, comme cela est expliqué en détail plus bas en référence aux figures 4 à 11.

Le boîtier de mesure 11 comporte en outre un connecteur 17 prévu pour recevoir un câble de connexion 18 au boîtier de commande 12 ainsi que cinq connecteurs « courant fort » pour des mesures spécifiques éventuelles. Il est également équipé d'au moins un connecteur 19 de type USB prévu pour la connexion à un dispositif requérant ce type de connexion, comme par exemple un périphérique de stockage USB.

Dans le mode de réalisation illustré, le boîtier de mesure 11 comporte en outre un dispositif de communication 20 sans fil, ce dispositif de communication 20 comportant par exemple une antenne wifi ou Bluetooth.

Le boîtier de mesure 11 est alimenté par une batterie 21 qui peut être fixée de façon amovible ou non amovible à ce boîtier de mesure 11.

Le boîtier de mesure 11 peut en outre comporter un écran (non représenté) permettant la visualisation d'informations pour l'utilisateur.

Le boîtier de commande 12, illustré plus en détail par les figures 3a et 3b, comporte notamment un écran d'affichage 22, des moyens de sélections d'options 23 dans un menu et au moins trois connecteurs. Selon un mode de réalisation préféré, l'un des connecteurs 24 est prévu pour être connecté au boîtier de mesure au moyen du câble de connexion souple 18 entre le boîtier de commande 12 et le boîtier de mesure 11. Un autre connecteur est prévu pour être connecté à une prise de référence de terre, dénommé prise de terre, et un autre connecteur est prévu pour être connecté à une borne neutre. Un connecteur supplémentaire peut être prévu, ce dernier étant utilisé pour être connecté à un conducteur polaire. Ces connecteurs peuvent notamment servir à mesurer un champ tournant dans un système triphasé.

La figure 3a représente le boîtier de commande 12 dans une première position dans laquelle une pointe de mesure 25 est connectée au boîtier 12. Cette pointe de mesure 25 est positionnée de façon à pouvoir être utilisée pour réaliser une mesure. Dans la figure 3b, la pointe de mesure 25 peut rester connectée électriquement au boîtier de commande 12 ou en être déconnectée, mais elle est dans une deuxième position dans laquelle cette pointe de mesure 25 n'est pas utilisée pour effectuer une mesure. Cette pointe de mesure 25 peut être placée dans un logement du boîtier de commande 12, ce qui évite de la perdre. Si la pointe de mesure 25 est rangée dans son logement, elle peut laisser la place à une connexion supplémentaire permettant d'utiliser ce boîtier de commande différemment. Il est également possible de prévoir une pointe de mesure interchangeable de façon à adapter cette pointe de mesure par exemple à différentes formes, dimensions ou types de prises électriques à tester.

De cette façon, en fonction de la mesure ou du type de mesure à effectuer, la pointe de mesure 25 peut être connectée au boitier de commande 12 et être placée dans une position d'utilisation ou au contraire être déconnectée du boîtier de commande 12 et/ou être placée dans une position rangée, ceci de façon simple et pratique.

Le boîtier de commande 12 comporte des boutons de sélection faisant partie des moyens de sélections d'options 23 et permettant de naviguer dans un menu affiché à l'écran d'affichage 22. Il comporte en outre un bouton de déclenchement 26, destiné à déclencher une mesure. Le bouton de déclenchement pourrait également être intégré à la pointe de mesure. Le boîtier de commande 12 comporte également trois diodes lumineuses 27 de signalisation ainsi qu'un dispositif de signalisation sonore 28 pour transmettre certaines informations à l'utilisateur, comme notamment l'état de la mesure, les résultats de cette mesure, etc.

Le boîtier de commande 12 peut également comporter des moyens de communication à distance qui peuvent par exemple utiliser des protocoles de communication tels que Wifi ou Bluetooth notamment. Le boîtier de commande 12 peut être en mesure de communiquer d'une part avec le boitier de mesure 11 et d'autre part avec un dispositif externe local ou distant. Un dispositif externe local est typiquement un ordinateur, une tablette ou un smartphone porté par l'utilisateur en charge d'effectuer les tests de l'installation électrique. Un dispositif externe distant peut être un centre de contrôle, de certification et/ou de gestion qui peut notamment être en charge de collecter les données mesurées et de les traiter en vue d'obtenir les informations souhaitées.

Le boîtier de commande 12 est capable de communiquer des données, des instructions ou d'autres formes d'informations au moins au boîtier de mesure 11. Cette communication peut se faire, selon le mode d'implémentation choisi par câble ou par communication sans fil.

Dans le mode de réalisation illustré par la figure 1, le boîtier de mesure 11 et le boîtier de commande 12 sont connectés entre eux au moyen du câble 18. Ce câble sert au moins à transmettre des valeurs mesurées par le boîtier de commande 12 au boîtier de mesure 11. Il peut également servir à échanger des messages, des instructions et/ou des informations entre le boîtier de commande 12 et le boîtier de mesure 11.

Si le câble 18 n'est pas utilisé pour l'échange de messages, d'instructions et/ou d'informations, ceux-ci peuvent être échangés au moyen d'une communication sans fil.

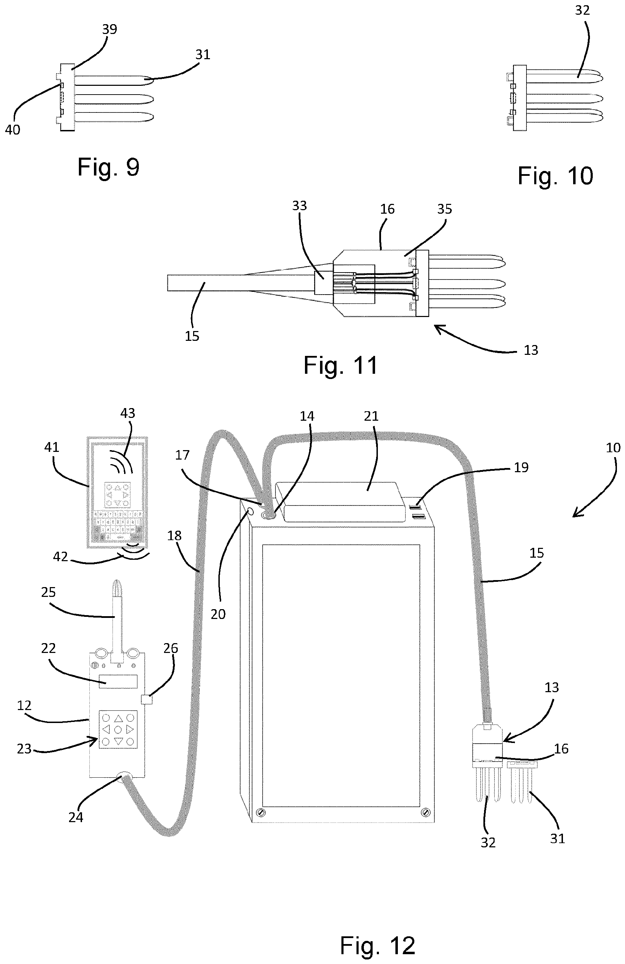

Comme indiqué précédemment, le dispositif de contrôle 10 de l'invention comporte une prise de test 13. Les figures 4 à 11 illustrent trois variantes de cette prise de test réalisées sous la forme d'un module 16 de prise de test. La première variante illustrée par les figures 4 à 6 comporte une seule pointe de test 30. La variante illustrée par la figure 9 comporte trois pointes de tests 31 disposées de façon à permettre des contrôles d'une prise monophasée et les figures 10 et 11 illustrent une variante dans laquelle le module de prise de test comporte cinq pointes de tests 32 disposées de façon à permettre des contrôles d'une prise triphasée.

Les éléments composant le module de prise de test illustré par les figures 4 à 6 sont illustrés dans une position démontée dans les figures 4 et 5. Ce module de prise de test comporte en premier lieu un bloc de prise mâle 33 représenté par la figure 4, connecté au câble souple 15 de façon à établir une connexion électrique avec le boîtier de mesure 11. Ce bloc de prise mâle 33 comporte une pluralité de connecteurs, certains d'entre eux étant prévus pour tester des installations de courant fort et d'autre pour des tests de courant faible.

Le module de prise de test comporte en outre un bloc de prise femelle 34 illustré par la figure 5 et agencé pour coopérer avec le bloc de prise mâle 33 et plus précisément pour pouvoir être connecté au moins à certains connecteurs du bloc de prise mâle 33.

Dans le mode de réalisation illustré par les figures 5 et 6, la pointe de test 30 est fixée à demeure sur le bloc de prise femelle 34. Des zones de la pointe de test 30 sont reliés électriquement à ces câbles disposés à l'intérieur de cette pointe de test et aboutissent à des connecteurs femelles disposés dans le bloc de prise femelle 34. Ces connecteurs femelles sont positionnés de façon à entrer en contact avec des connecteurs choisis du bloc de prise mâle 33.

A titre d'exemple, si le bloc de prise femelle 34 supporte une pointe de test destinée à effectuer des mesures en courant faible, cette pointe de test est connectée à des connecteurs qui seront en contact avec les connecteurs destinés aux mesures en courant faible du bloc de prise mâle 33.

Les figures 4, 7, 8 et 9 illustrent un module de prise de test destiné en particulier à effectuer des contrôles de prises monophasées. A cet effet, le module de prise de test comporte trois pointes de test 31 comme cela est illustré plus spécifiquement par la figure 9. Dans ce mode de réalisation, le module de prise de test comporte le bloc de prise mâle 33 illustré par la figure 4. Ce bloc de prise mâle 33 comporte un adaptateur femelle 35 illustré par les figures 7 et 8 et agencé pour pouvoir être connectée mécaniquement et électriquement au bloc de prise mâle 33. Cet adaptateur femelle 35 comporte une zone libre 36, disposée généralement du côté opposé au bloc de prise mâle 33, et dans laquelle affleure des contacts électriques 37. Cet adaptateur femelle 35 peut également comporter deux rails 38 de guidage dont la fonction est expliquée plus bas.

Le module 16 de prise de test dénommé dans jargon électrotechnique « Type 13 » comporte un bloc amovible de pointes de test 31 illustré par la figure 9, muni de trois pointes de test.

Le bloc de pointes de test 31 est généralement formé d'un support 39 portant d'un côté les pointes de test et de l'autre, au moins une connexion électrique 40 apparente. De façon générale, chaque pointe de test est connectée électriquement à une connexion apparente, cette connexion apparente étant par exemple réalisée sous la forme d'une languette conductrice souple dépassant du support 39.

Le support 39 peut être configuré de façon à pouvoir coulisser dans les rails de guidage 38 de l'adaptateur femelle 35. Il est clair que d'autres systèmes de fixation amovible sont également utilisables.

Les connexions électriques apparentes du support 39 sont positionnées de telle façon que, lorsque ce support 39 est coulissé le long des rails de guidage 38 du bloc de prise femelle 35, elles soient en contact électrique avec les contacts électriques de la zone libre 36 du bloc de prise femelle 35. De cette façon, les éléments conducteurs des pointes de test sont connectés aux fils correspondants du câble 15 connecté au bloc de prise mâle 33.

Le mode de réalisation illustré par les figures 4, 7, 8, 10 et 11 est similaire à celui illustré par les figures 4, 7, 8 et 9 à ceci près que le bloc de pointes de test 32 comporte cinq pointes de tests dénommé dans jargon électrotechnique « Type 15 » au lieu de trois.

Le bloc de prise femelle peut avoir plusieurs contacts électriques disposés en différents endroits et affleurant dans différentes positions de la zone libre 36, de façon à permettre une connexion électrique avec plusieurs blocs de pointes de tests, de façon à s'adapter à différentes configurations d'installations électriques à tester.

De cette manière, lors du test de différentes installations, il n'est pas nécessaire de changer de câble ou de connecteur. Il suffit de choisir le bloc de pointes de test adapté aux mesures à effectuer. Il est bien entendu possible de réaliser la prise de test sous forme de modules, selon une forme différente. Par exemple le bloc de prise femelle 34 peut être fixé à demeure au bloc de prise mâle 33 et comporter une connexion pour une pointe de test telle que représentée par la figure 5, une prise de type T13 ou de type T15 ou tout autre type de prises électriques existantes.

Selon un mode de réalisation avantageux, le type de prise de test 13 qui est connecté au boîtier de mesure 11 peut être détecté automatiquement, ce qui peut être utilisé pour influencer le déroulement d'une mesure, comme cela est décrit plus bas.

La figure 12 illustre un deuxième mode de réalisation de l'invention dans lequel le dispositif de contrôle 10 coopère avec un boîtier de communication 41 ou comprend un tel boîtier de communication. Celui-ci qui peut par exemple être réalisé sous la forme d'un smartphone ou d'un appareil dédié.

Le boitier de communication 41 peut prendre en charge une partie des fonctions du boîtier de commande 12 décrit en référence aux figures 1 à 3. De façon générale, en plus de prendre en charge une partie des fonctions du boîtier de commande 12, le boîtier de communication 41 donne accès à des fonctions supplémentaires.

Dans ce but, le boîtier de communication 41 comporte notamment une voie de communication 42 avec le boîtier de commande 12. Cette voie de communication peut également être établie entre le boîtier de communication 41 et le boîtier de mesure 11. Cette voie de communication 42 peut par exemple utiliser les protocoles de communication Wifi ou Bluetooth.

Le boîtier de communication 41 comporte généralement également une voie de communication distante 43 avec un centre de gestion. Cette voie de communication distante 43 peut être unidirectionnelle et permettre la transmission d'informations depuis le centre de gestion vers le boîtier de communication 41. Elle peut également être unidirectionnelle et permettre la transmission de données depuis le boîtier de communication 41 vers le centre de gestion. Selon un mode de réalisation préféré, cette voie de communication 42 est toutefois bidirectionnelle entre le boîtier de communication 41 et le centre de gestion.

Selon un exemple de réalisation concret, le boîtier de communication 41 reçoit des informations d'un centre de gestion. Ces informations peuvent par exemple être :
- des normes à respecter en fonction du type de mesures
- des formats de données utilisables par le centre de gestion
- un protocole de mesure à mettre en œuvre, ...

Lorsque l'utilisateur doit effectuer des tests, il peut utiliser le boîtier de communication 41 pour introduire des données requises pour le contrôle. Ces données peuvent par exemple être :
- des coordonnées relatives à l'installation à contrôler, telles que par exemple le nom du propriétaire, l'adresse, le numéro de compteur ...
- des informations relatives à l'installation à tester, telle que par exemple le type de local (cuisine, locaux d'habitation, locaux industriels, ..)
- des informations relatives à la personne qui effectue le contrôle ;
- des informations sur le type d'appareil de mesure, numéro de série...

Au moment du démarrage des tests, le boîtier de communication 41 ou le boîtier de commande 12 peuvent afficher des instructions à destination de l'utilisateur. Ces instructions peuvent indiquer par exemple quelles sont les mesures qui doivent être faites, quels sont les données qui doivent être introduites, etc.

Les mesures sont réalisées par l'utilisateur, puis les résultats des mesures peuvent être mémorisé dans la mémoire du boîtier de mesure 11. Les résultats des mesures peuvent également être transmis au boîtier de communication 41. Ce dernier peut contenir des données concernant les caractéristiques des dispositifs de protection, des normes ou des valeurs à respecter. Dans ce cas, les valeurs mesurées peuvent être comparées aux valeurs à respecter, en fonction du type de mesures qui ont été effectuées. Le boîtier de commande 12 peut afficher une information à destination de l'utilisateur pour lui indiquer si les valeurs obtenues respectent les normes ou non. Il est également possible de transmettre une information au boîtier de commande 12 et utiliser les diodes électroluminescentes 27 pour permettre à l'utilisateur de voir immédiatement si les résultats des mesures effectuées répondent aux normes ou non.

Les résultats de ces mesures peuvent être transmis au centre de gestion, par l'intermédiaire du boîtier de communication 41, dans un format qui est compatible avec un traitement automatique par ce centre de gestion.

Du fait que le centre de gestion peut transmettre des informations au boîtier de communication 41, il est possible de prendre en compte les normes à respecter en fonction de paramètres tels que le type de lieu à tester, éventuellement l'âge de l'installation, etc. En fonction de ces normes, il est possible que des mêmes valeurs mesurées n'aboutissent pas au même résultat quant à la conformité de l'installation électrique. Le fait que l'installation soit conforme ou non peut être immédiatement affiché sur le boîtier de communication 41 ou sur le boîtier de commande 12, de façon à permettre à l'utilisateur d'avoir cette information à disposition sans devoir effectuer les mesures, retranscrire manuellement ces résultats, les transmettre à un centre de gestion puis attendre de recevoir l'information en retour lorsque les données auront été traitées par le centre de gestion.

La description ci-dessous illustre un exemple de test d'installation électrique dans lequel le test effectué est une mesure standard d'isolement et de continuité. Dans cet exemple, la pointe de mesure 30 est connectée électriquement au câble 15 du boîtier de mesure 11. La pointe de mesure 25 est connectée électriquement au boîtier de commande 12.

Un menu visible sur le boîtier de commande 12 est affiché à l'écran 22 de ce dernier et les moyens de sélection d'options 23 permettent de sélectionner des paramètres de la mesure et d'indiquer que les mesures qui vont suivre font partie d'un protocole de mesure défini et choisi dans ce menu.

Le dispositif de mesure 10 est utilisé en plaçant le boîtier de mesure 11 dans un endroit commode pour l'utilisateur, par exemple dans le dos, ceinturé autour de la taille ou encore fixé par un système sur le bras ou sur la jambe. L'utilisateur ne porte et ne manipule que le boîtier de commande 12 lors d'une mesure.

Ce boîtier de commande 12 peut être réalisé de façon à être maniable, léger et pratique et les dimensions ou le poids de ce boîtier de commande 12 ne sont pas conditionnés par la quantité de fonctions que le dispositif de contrôle 10 est capable de mettre en œuvre ou par la précision atteinte par ce dispositif.

Selon une première variante, l'utilisateur indique les mesures à effectuer au moyen du boîtier de commande 12 en sélectionnant les options correspondantes sur le menu. Ce boîtier de commande 12 envoie une commande au boîtier de mesure 11, cette commande indiquant quelle mesure ou quel type de mesures est à effectuer. Selon une deuxième variante, le type de mesure est aussi guidé selon le type de prise test 13 amovible choisi. Par exemple, si le type de prise sélectionné est une prise triphasée telle que représentée sous la référence 32 à la figure 10, le boitier de mesure 11 va recevoir l'information qu'il faut effectuer une mesure de tension entre les trois phases ainsi que le champ tournant.

Lorsque les mesures sont effectuées au moyen des pointes de mesures connectées respectivement au boîtier de mesure 11 et au boîtier de commande 12, les résultats de ces mesures sont collectés par le boîtier de mesure 11, puis sont mémorisées dans la mémoire de ce boîtier de mesure 11. Ces mesures peuvent être des mesures individuelles ou faire partie d'un ensemble de mesures faisant partie d'un protocole de mesures par exemple. Les valeurs mesurées peuvent être mémorisées en lien avec le protocole duquel elles font partie.

L'exemple ci-dessous décrit un exemple concret d'un protocole de mesure comportant les mesures suivantes :
- Mesure d'isolement et de continuité
- Mesure du courant maximal de court-circuit Icc max
- Mesure DDR (dispositifs à courant différentiel résiduel)
- Mesure du courant de court-circuit Icc ainsi que tension et fréquence
- Mesure de terre
- Champ tournant

Dans cet exemple, la mesure d'isolement et de continuité a été décrite ci-dessus. Lorsque cette mesure d'isolement et de continuité a été effectuée, la mesure Icc max peut être démarrée sans changer de connecteurs ou de câbles. Le boîtier de commande 12 est utilisé pour indiquer que les prochaines mesures font partie de cette mesure Icc max. Lorsque les mesures sont réalisées au moyen du boîtier de commande 12 et du boîtier de mesure 11, elles sont également mémorisées dans une mémoire de ce boîtier de mesure 11.

Pour ce qui concerne la mesure DDR, comme pour ce qui concerne la mesure Icc max, les mêmes connecteurs et les mêmes connexions peuvent être utilisées. Le boîtier de commande 12 est utilisé pour indiquer quel type de mesure va être faite. Les résultats des mesures sont mémorisés en conséquence dans le boîtier de mesure 11.

Dans les appareils de l'art antérieur, il est courant que deux câbles supplémentaires soient raccordés à l'appareil de mesure, ce qui implique que cinq câbles sont raccordés sur le même appareil. Il en résulte un risque d'utiliser un faux câble et d'emmêler ces câbles, ce qui rend la mesure plus compliquée et moins pratique à réaliser. De plus, la manipulation de l'appareil de mesure pour indiquer quel type de mesure est à effectuer implique la manipulation d'un appareil volumineux, lourd et peu pratique, auquel sont raccordés tous les câbles de mesure.

Pour ce qui concerne la mesure Icc et tension, dans le dispositif de l'invention, la pointe de mesure 25 connectée au boîtier de commande 12 peut être déconnectée de ce boîtier de commande ou rangée dans un logement du boîtier de commande. La pointe de mesure du boîtier de mesure 11 peut également être déconnectée du boîtier de mesure et être remplacée par une prise de test 13. Cette prise de test peut avoir des formes différentes selon la forme ou le type de prise électrique à tester. La prise peut être associée à un adaptateur permettant de la connecter à plusieurs types de prises de formes différentes Elle pourrait également comporter des broches pivotables ou rétractables de façon à ce que les broches nécessaires à la mesure soient extraites ou accessibles et que les autres broches soient retirées de façon à ne pas empêcher la prise de test d'entrer dans la prise à tester.

Lorsque les mesures ont été effectuées et que les tests sont terminés, les résultats de ces mesures peuvent être transmis par le boîtier de mesure 11 ou le boîtier de communication 41 à un dispositif externe. De nombreuses variantes sont envisageables pour la transmission des résultats des mesures. Selon l'une de ces variantes, les résultats sont transmis de façon « brute », c'est-à-dire sans traitement et sans mise en forme, à un centre de traitement. A l'autre extrême, les résultats peuvent être traités par le module de traitement du boîtier de mesure 11 ou par le boîtier de communication 41 de façon à être adaptés au format acceptable pour l'entité en charge de collecter les résultats des tests. Les variantes intermédiaires entre l'absence de traitement et le traitement complet sont bien entendu envisageables.

Les résultats des mesures peuvent être communiqués du boîtier de mesure 11 à un dispositif externe au moyen d'une liaison connectée physiquement. Le dispositif externe peut par exemple être une clé de stockage avec une connexion USB.

La communication des résultats peut se faire par une liaison locale sans fil utilisant par exemple le protocole de communication Bluetooth. Le dispositif externe pourrait être par exemple une tablette ou un dispositif électronique dédié.

La communication pourrait également être faite à distance, par exemple en utilisant un réseau Wifi, de façon à transmettre les informations depuis le boîtier de mesure 11 à un centre de traitement distant. Cette communication présente l'avantage d'éviter les retranscriptions des valeurs des mesures, ce qui présente un gain de temps important et évite les erreurs de retranscription manuelles.

Le dispositif de contrôle de l'invention permet donc d'effectuer des mesures de façon simple et pratique, en évitant au maximum des risques d'erreurs et de fausses manipulations. Il permet également de transmettre les données automatiquement, sans retranscription manuelle, ce qui évite également les erreurs.

## Revendications

1. Dispositif de contrôle d'installations électriques, comportant un boîtier de mesure (11) agencé pour recevoir des valeurs de mesure de paramètres contrôlés, ce dispositif de contrôle (10) étant **caractérisé en ce qu'**il comporte en outre au moins un boîtier de commande (12) distinct dudit boîtier de mesure (11) et connecté à ce boîtier de mesure (11) par une voie de communication.

2. Dispositif de contrôle d'installations électriques selon la revendication 1, **caractérisé en ce que** la voie de communication entre le boîtier de commande (12) et le boîtier de mesure (11) est une voie de communication par câble.

3. Dispositif de contrôle d'installations électriques selon la revendication 1, **caractérisé en ce que** le boîtier de mesure (11) comporte au moins un module de traitement de valeurs mesurées pendant les contrôles.

4. Dispositif de contrôle d'installations électriques selon la revendication 1, **caractérisé en ce qu'**il comporte au moins un boîtier de communication (41) connecté au moins à l'un des boîtiers parmi le boîtier de commande (12) et le boîtier de mesure (12) et agencé pour transmettre des informations, des instructions et/ou des résultats de mesures à au moins l'un des boîtiers de commande (12) ou de mesure (11) et/ou à recevoir des informations, des instructions et/ou des résultats de mesures d'au moins l'un des boîtiers de commande (12) ou de mesure (11).

5. Dispositif de contrôle d'installations électriques selon la revendication 1 ou 4, **caractérisé en ce qu'**au moins l'un des boîtiers parmi le boîtier de commande (12) et le boîtier de communication (41) comporte des moyens de sélection de paramètres à contrôler.

6. Dispositif de contrôle d'installations électriques selon la revendication 1 ou 4, **caractérisé en ce qu'**au moins l'un des boîtiers parmi le boîtier de commande (12), le boîtier de communication (41) et le boîtier de mesure (11) comporte des moyens de comparaison entre des résultats de mesures de paramètres contrôlés et de valeurs de normes correspondant aux contrôles effectués.

7. Dispositif de contrôle d'installations électriques selon la revendication 6, **caractérisé en ce que** le résultat de la comparaison est affiché à destination de l'utilisateur.

8. Dispositif de contrôle d'installations électriques selon la revendication 1, **caractérisé en ce que** le boîtier de mesure (11) comporte des moyens de transmission à distance de résultats des contrôles.

9. Dispositif de contrôle d'installations électriques selon la revendication 8, **caractérisé en ce que** les moyens de transmission sont agencés pour transmettre des informations et/ou des résultats de mesure à un centre de gestion distant.

10. Dispositif de contrôle d'installations électriques selon la revendication 1, **caractérisé en ce qu'**il comporte au moins une prise de test (13) modulaire.

11. Dispositif de contrôle d'installations électriques selon la revendication 8, **caractérisé en ce qu'**il comporte des moyens de reconnaissance automatique de la prise de test (13) modulaire connectée à ce dispositif de contrôle (10).

12. Méthode de contrôle d'installations électriques au moyen d'un dispositif de contrôle (10) comportant au moins un boîtier de mesure (11) agencé pour recevoir des valeurs de mesure de paramètres testés et un boîtier de commande (12) distinct dudit boîtier de mesure (11) et connecté à ce boîtier de mesure (11) par une voie de communication, cette méthode comportant les étapes suivantes :
• sélection sur le boîtier de commande (12) et/ou le boîtier de communication (41) d'une mesure à effectuer ;
• mesure des paramètres et de valeurs en fonction de la sélection ;
• transmission de données représentatives des résultats des mesures à un centre de gestion distant.

13. Méthode de contrôle d'installations électriques selon l'une quelconque des revendications 12, **caractérisé en ce que** les valeurs mesurées des paramètres sont traitées dans le boîtier de mesure (11).

14. Méthode de contrôle d'installations électriques selon l'une quelconque des revendications 12 ou 13, **caractérisé en ce que** les valeurs mesurées des paramètres sont comparées à des valeurs normatives correspondant aux contrôles effectués et **en ce que** le résultat de la comparaison est affiché à destination de l'utilisateur.

15. Méthode de contrôle d'installations électriques selon l'une quelconque des revendications 12 à 14, **caractérisé en ce que** le résultat de la comparaison des valeurs mesurées des paramètres et des valeurs normatives sont affichés sur le dispositif de contrôle.
